# EUROPÄISCHE PATENTANMELDUNG

(11) **EP 3 375 658 A2**
(43) Veröffentlichungstag der Anmeldung: **19.09.2018**
(21) Anmeldenummer: 18020024.8
(22) Anmeldetag: 16.01.2018
(51) Int. Cl.: B60L 11/18, H02J 7/00

(54) **LADESTATIONSSYSTEM FÜR ELEKTROFAHRZEUGE**

(30) Priorität: 16.03.2017 DE 102017105632
(71) Anmelder: Dr. Ing. h.c. F. Porsche AG, 70435 Stuttgart (DE)
(72) Erfinder: Reber, Volker, 74544 Michelbach an der Bilz (DE); Oestreicher, Ralf, 71065 Sindelfingen (DE); Kiefer, Michael, 70563 Stuttgart (DE); Zander, Steve, 71672 Marbach am Neckar (DE); Wischnack, Thomas, 76185 Karlsruhe (DE)

(57) **Zusammenfassung**

Die vorliegende Erfindung betrifft ein Ladestationssystem, insbesondere für Elektrofahrzeuge, wobei das Ladestationssystem mindestens ein Gehäuse aufweist, wobei das Ladestationssystem eine Mehrzahl an Hauptkomponenten aufweist, dadurch gekennzeichnet, dass das Gehäuse und die Hauptkomponenten so standardisiert sind, dass sich die Hauptkomponenten im Gehäuse modular anordnen lassen.

Die vorliegende Erfindung betrifft ferner ein zugehöriges Verfahren zum Aufbau einer Ladestation.

## Beschreibung

Die vorliegende Erfindung betrifft ein Ladestationssystem, insbesondere für Elektrofahrzeuge.

Ladestationssysteme zur Versorgung von Elektrofahrzeugen mit elektrischer Energie sind aus dem Stand der Technik bekannt. Ladestationen sind mit einer oder mehreren Ladeeinheiten ausgestattet. Diese Ladeeinheiten sind üblicherweise als komplette, vorgefertigte Einheit ausgebildet. In einer Einheit finden sich Vorrichtungen zur Stromversorgung, zur Kühlung, Bedienelemente sowie das Ladeanschlusskabel in einer festen Anordnung, Anzahl und Konfiguration. Dabei sind die Ladeeinheiten für einen festen Anwendungsfall und/oder einen bestimmten Einsatzort konstruiert. Neue Anwendungsfälle und/oder Standorte mit gegenüber bisherigen Standorten veränderten Bedingungen erfordern die Planung und den Bau neuer Ladeeinheiten. Es ist mit bisher bekannten Ladestationssystemen nicht möglich, beim Aufbau einer Ladestation flexibel die örtlichen und aktuellen Gegebenheiten und Anforderungen zu berücksichtigen.

Es ist Aufgabe der vorliegenden Erfindung, ein Ladestationssystem und ein entsprechendes Verfahren zum Aufbau einer solchen Ladestation zur Verfügung zu stellen, das es ermöglicht, beim Aufbau einer Ladestation auf örtliche und aktuelle Anforderungen und Gegebenheiten flexibel zu reagieren.

Diese Aufgabe wird gelöst durch ein Ladestationssystem, insbesondere für Elektrofahrzeuge, wobei das Ladestationssystem mindestens ein Gehäuse aufweist, wobei das Ladestationssystem eine Mehrzahl an Hauptkomponenten aufweist, dadurch gekennzeichnet, dass das Gehäuse und die Hauptkomponenten so standardisiert sind, dass sich die Hauptkomponenten im Gehäuse modular anordnen lassen.

Hiermit ist es vorteilhaft möglich beim Aufbau einer Ladestation flexibel auf Standortanforderungen zu reagieren. Insbesondere können die elektrische Leistung und die Kühlleistung der Ladestation unabhängig voneinander gewählt werden. Die elektrische Leistung der Ladestation kann beispielsweise verändert werden, ohne dass die Kühlleistung verändert wird. Umgekehrt kann auch die Kühlleistung der Ladestation verändert werden, ohne dass die elektrische Leistungsfähigkeit der Ladestation verändert wird. Es wird hiermit vorteilhaft ein Ladestationssystem zur Verfügung gestellt, dass eine Skalierung der elektrischen Leistung einer Ladestation unabhängig von der Kühlleistung der Ladestation ermöglicht. Es wird hiermit vorteilhaft ein Ladestationssystem zur Verfügung gestellt, dass eine Skalierung der Kühlleistung einer Ladestation unabhängig von der elektrischen Leistung der Ladestation ermöglicht.

In einer bevorzugten Ausführungsform der vorliegenden Erfindung, weisen die Hauptkomponenten und das Gehäuse in ihren Maßen eine aufeinander abgestimmte Standardisierung auf, wobei insbesondere das Gehäuse Innenmaße aufweist, die durch die Außenmaße der Hauptkomponenten bestimmt sind.

In einer bevorzugten Ausführungsform der vorliegenden Erfindung weist das Gehäuse Innenmaße auf, die eine Anordnung mehrerer Hauptkomponenten im Gehäuse unter optimaler Ausnutzung des Volumens des Gehäuses ermöglichen. Insbesondere weist das Gehäuse Innenmaße auf, die sich aus einem ganzzahligen Vielfachen der Außenmaße einer Hauptkomponente und eines zwischen Gehäuse und Hauptkomponente einzuhaltenden Abstandes zusammensetzen. In einer bevorzugten Ausführungsform der vorliegenden Erfindung hat das Gehäuse eine quadratische Grundfläche. In einer weiteren bevorzugten Ausführungsform sind die Außenmaße der Grundfläche des Gehäuses so gewählt, dass das Gehäuse mit der Grundseite auf einer oder mehreren Europaletten platziert werden kann, ohne überzustehen. Europalette im Sinne dieser Erfindung bezeichnet eine nach EN 13698-1 genormte, mehrwegfähige Transportpalette. In einer bevorzugten Ausführungsform der vorliegenden Erfindung weist die Grundfläche des Gehäuses Außenkanten von einer maximalen Länge von 1200 mm auf. In einer alternativen bevorzugten Ausführungsform weist die Grundfläche des Gehäuses Außenkanten von einer maximalen Länge eines ganzzahligen Vielfachen von 1200 mm auf.

In einer weiteren bevorzugten Ausführungsform der vorliegenden Erfindung, weist das Ladestationssystem eine Mehrzahl an Hauptkomponenten auf, wobei jede dieser Hauptkomponenten einen Schaltschrank aufweist, wobei die Hauptkomponente mindestens ein Modul aufweist, wobei die Architektur des Moduls dadurch gekennzeichnet ist, dass sich das Modul im Schaltschrank modular anordnen lässt.

In einer bevorzugten Ausführungsform der vorliegenden Erfindung ist der Schaltschrank als 19-Zoll-Rack ausgeführt. Im Sinne der vorliegenden Erfindung bezeichnet ein 19-Zoll-Rack ein nach EIA 310-D, IEC 60297 und DIN 41494 SC48D genormtes Gestell zur Aufnahme elektronischer Vorrichtungen, wobei das Gestell eine genormte Breite von 19 Zoll, d.h. 482,6 mm aufweist, wobei das Gestell weiterhin über Haltevorrichtungen für die elektronischen Vorrichtungen aufweist, die vertikal in einem genormten Abstand von einer Höheneinheit angebracht sind, wobei eine Höheneinheit 1,75 Zoll, d.h. 44,45 mm, entspricht.

In einer bevorzugten Ausführungsform der vorliegenden Erfindung sind die Außenmaße der Module so gewählt, dass eine Anordnung in einem 19-Zoll-Rack möglich ist.

Es wird hiermit vorteilhaft eine Hauptkomponente zur Verfügung gestellt, die modular gestaltet werden kann. Es ist hiermit vorteilhaft möglich, Hauptkomponenten mit verschiedenen Eigenschaften schnell und einfach aus vorgegebenen Modulen aufzubauen. Hierdurch ist es vorteilhaft möglich, die Hauptkomponente mit reduziertem Aufwand an neue Gegebenheiten und Anforderungen anzupassen, die sich beispielsweise aus dem Standort und/oder Veränderungen in den technischen Anforderungen und/oder Veränderungen im Konsumentenverhalten ergeben.

In einer bevorzugten Ausführungsform der vorliegenden Erfindung, weist das Ladestationssystem mindestens eine Hauptkomponente auf, wobei die Hauptkomponente eine Mehrzahl an Modulen aufweist, dadurch gekennzeichnet, dass die Module ausschließlich Stromversorgungsmodule sind.

Hiermit wird vorteilhaft eine Hauptkomponente zur Verfügung gestellt, die ausschließlich der Stromversorgung dient. Es ist hiermit vorteilhaft möglich, die an die Stromversorgung der Ladestation gestellten Anforderungen und Einschränkungen ohne Rücksicht auf zusätzliche und gegebenenfalls entgegenstehende Anforderungen und Einschränkung anderer Komponenten zu berücksichtigen.

Beispielsweise ist es Aufgabe der Stromversorgungskomponente, den aus dem stationären Stromnetz bezogenen Wechselstrom in für das Aufladen der Endnutzer, beispielsweise Elektrofahrzeuge, effizienten Gleichstrom umzuwandeln. Dazu wird die Stromversorgungskomponente mit einer Wechselspannungsleitung mit dem stationären Stromnetz verbunden. Dazu wird die Stromversorgungskomponente über eine Gleichspannungsleitung mit einer Ladevorrichtung verbunden. Aufgrund unterschiedlicher technischer Anforderungen können Wechselspannungsleitungen um ein Vielfaches länger ausgeführt werden als Gleichspannungsleitungen. Beispielsweise können Wechselspannungsleitungen eine Länge von bis zu 1000m aufweisen, während Gleichspannungsleitungen eine Länge von bis zu 100m aufweisen können. Die unterschiedliche, technische bedingte Maximallänge von Gleichspannungs- und Wechselstromleitungen stellt eine besondere Anforderung an die Stromversorgungskomponente dar, die aufgrund des modularen Aufbaus des Ladestationssystems vorteilhafterweise ohne Rücksicht auf die Anforderungen an die übrigen Komponenten der Ladestation Rechnung getragen werden kann.

In einer bevorzugten Ausführungsform der vorliegenden Erfindung weist die Hauptkomponente genau ein Stromversorgungsmodul auf. In einer alternativen bevorzugten Ausführungsform weist die Hauptkomponente mindestens zwei Stromversorgungsmodule auf.

In einer bevorzugten Ausführungsform der vorliegenden Erfindung weist das Ladestationssystem einen ersten Stromversorgungsmodultyp auf und mindestens einen zweiten Stromversorgungsmodultyp auf, wobei sich der erste und der zweite Stromversorgungsmodultyp in mindestens einer Eigenschaft unterscheiden. In einer bevorzugten Ausführungsform der vorliegenden Erfindung weist der erste Stromversorgungsmodultyp eine erste Architektur auf und der zweite Stromversorgungsmodultyp eine zweite Architektur auf, die von der ersten Architektur verschieden ist. Dabei bezeichnet Architektur im Sinne der vorliegenden Erfindung die Art und Anordnung der elektrischen Bauteile, aus der das Stromversorgungsmodul zusammengesetzt ist.

Im Sinne der vorliegenden Erfindung sind Bauteile beispielsweise, aber nicht ausschließlich Einheiten zur Umwandlung von Wechselstrom in Gleichstrom (AC/DC units) und Einheiten zur Umwandlung von Gleichstrom in Gleichstrom (DC/DC units) in beliebiger Ausführung.

In einer bevorzugten Ausführungsform der vorliegenden Erfindung, weist das Ladestationssystem mindestens eine Hauptkomponente auf, wobei die Hauptkomponente eine Mehrzahl an Modulen aufweist, dadurch gekennzeichnet, dass die Hauptkomponente mindestens ein Stromversorgungsmodul und ein Kühlmodul aufweist.

Es wird hiermit vorteilhaft eine Hauptkomponente zur Verfügung gestellt, die Kühlung und Stromversorgung kombiniert. Eine Hauptkomponente, die mindestens ein Kühlmodul und mindestens ein Stromversorgungsmodul aufweist, wird im Folgenden als Stromversorgungs-Kühl-Kombinationskomponente bezeichnet.

In einer bevorzugten Ausführungsform der vorliegenden Erfindung, weist das Ladestationssystem mindestens eine Hauptkomponente auf, wobei die Hauptkomponente eine Mehrzahl an Modulen aufweist, dadurch gekennzeichnet, dass die Module ausschließlich Kühlmodule sind.
Hiermit wird vorteilhaft eine Hauptkomponente allein zur Kühlung zur Verfügung gestellt. Es ist hiermit vorteilhaft möglich, die an die Kühlung der Ladestation gestellten Anforderungen und Einschränkungen ohne Rücksicht auf zusätzliche und gegebenenfalls entgegenstehende Anforderungen und Einschränkung anderer Komponenten, zu berücksichtigen.

In einer bevorzugten Ausführungsform der vorliegenden Erfindung weist die Hauptkomponente genau ein Kühlmodul auf. In einer alternativen bevorzugten Ausführungsform weist die Hauptkomponente mindestens zwei Kühlmodule auf.

In einer bevorzugten Ausführungsform der vorliegenden Erfindung weist das Ladestationssystem einen ersten Kühlmodultyp auf und mindestens einen zweiten Kühlmodultyp auf, wobei sich der erste und der zweite Kühlmodultyp in mindestens einer Eigenschaft unterscheiden. In einer bevorzugten Ausführungsform der vorliegenden Erfindung weist der erste Kühlmodultyp eine erste Kühlleistung auf und der zweite Kühlmodultyp eine zweite Kühlleistung auf, die von der ersten Kühlleistung verschieden ist.

In einer bevorzugten Ausführungsform der vorliegenden Erfindung, weist das Ladestationssystem eine Ladesäule auf. In einer bevorzugten Ausführungsform der vorliegenden Erfindung weist die Ladesäule Bedienelemente zur Bedienung durch einen Nutzer der Ladesäule auf.

In einer bevorzugten Ausführungsform der vorliegenden Erfindung, weist das Ladestationssystem eine Transformationsstation auf.

In einer bevorzugten Ausführungsform der vorliegenden Erfindung, ist das mindestens eine Gehäuse aus Stahlblech, Stahlplatten oder Beton gefertigt ist.
Es wird hiermit vorteilhaft ein Gehäuse zur Verfügung gestellt, das im Freien sowie in Gebäuden aufstellbar ist.

In einer bevorzugten Ausführungsform der vorliegenden Erfindung, weist das mindestens eine Gehäuse genau eine Tür auf. Es ist hiermit vorteilhaft möglich, nach dem Aufstellen des mit Hauptkomponenten bestückten Gehäuses die Hauptkomponenten auszutauschen und/oder Reparaturen und/oder Wartungsarbeiten an den Hauptkomponenten und deren Leitungen vorzunehmen, ohne das Gehäuse zu beschädigen.

In einer bevorzugten Ausführungsform der vorliegenden Erfindung, weist das Ladestationssystem ein erstes Gehäuse und mindestens ein neben oder über dem ersten Gehäuse befindliches, zweites Gehäuse auf.

Es wird hiermit vorteilhaft ein Ladestationssystem zur Verfügung gestellt, dessen Gehäuse sich neben- und/oder aufeinanderstapeln lassen. Es ist hiermit vorteilhaft möglich, den zur Unterbringung der Hauptkomponenten vorhandenen Innenraum zu vergrößern.

Weitere Einzelheiten, Merkmale und Vorteile der Erfindung ergeben sich aus den Zeichnungen sowie aus der nachfolgenden Beschreibung von bevorzugten Ausführungsformen anhand der Zeichnungen. Die Zeichnungen illustrieren dabei lediglich beispielhafte Ausführungsformen der Erfindung, welche den Erfindungsgedanken nicht einschränken.
Figur 1 illustriert schematisch den Aufbau einer Ladestation mit einer Ladesäule und einer Stromversorgungs-Kühl-Kombinationskomponente.
Figur 2 illustriert schematisch den Aufbau einer Ladestation mit zwei Ladesäulen und zwei Stromversorgungs-Kühl-Kombinationskomponenten.
Figur 3 illustriert schematisch den Aufbau einer Ladestation mit zwei Ladesäulen und einer Stromversorgungskomponente und einer Kühlkomponente.
Figur 4 illustriert schematisch den Aufbau einer Ladestation mit vier Ladesäulen und zwei Stromversorgungskomponenten und einer Kühlkomponente, sowie einer Transformationsstation.
Figur 5 illustriert schematisch den Aufbau einer Ladestation mit sechs Ladesäulen und drei Stromversorgungskomponenten und einer Kühlkomponente, sowie einer Transformationsstation.

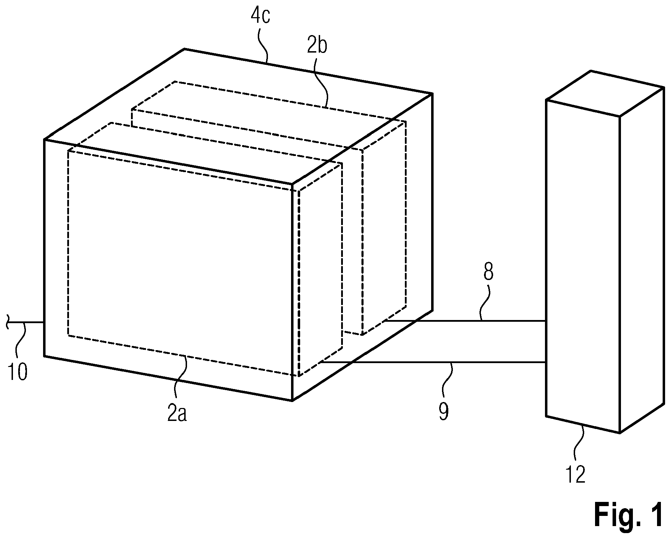

In Figur 1 ist eine Ladestation 1 mit einer Stromversorgungs-Kühl-Kombinationskomponente 4c und einer Ladesäule 12 gemäß der vorliegenden Erfindung schematisch dargestellt.
In einer bevorzugten Ausführungsform der vorliegenden Erfindung, ist die Hauptkomponente 4c mit einem Stromversorgungsmodul 2a und einem Kühlmodul 2b ausgestattet. Die Hauptkomponente 4c weist einen ersten Eingang für eine Wechselstromquelle und Wechselstromleitung 10 auf. Die Hauptkomponente 4c weist ferner einen ersten Ausgang für die Kühlmittelleitung 8 und einen zweiten Ausgang für Gleichstrom auf. Die Ladestation weist ferner eine Ladesäule 12 auf, die mit der Hauptkomponente 4c mittels Kühlmittelleitung 8 und Gleichstromleitung 9 verbunden ist. Es wird hiermit vorteilhaft eine Ladestation mit einer Ladesäule zur Verfügung gestellt. Vorteilhaft ist die Kühlung direkt in einer Komponente mit dem Stromversorgungsmodul verbaut.

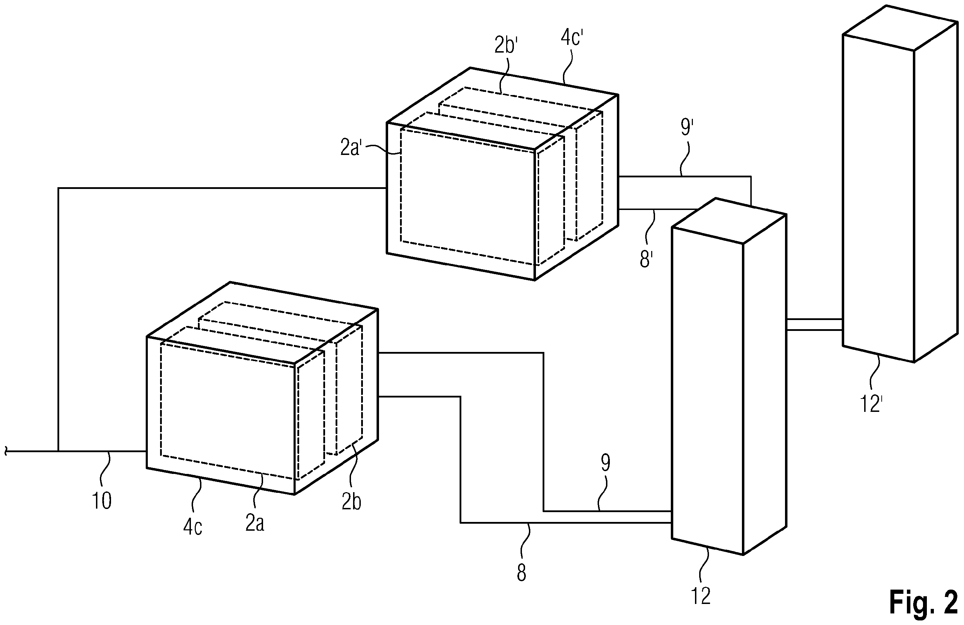

In Figur 2 ist eine Ladestation 1 mit zwei Stromversorgungs-Kühl-Kombinationskomponenten 4c und 4c' und zwei Ladesäulen 12 und 12' gemäß der vorliegenden Erfindung schematisch dargestellt.
In einer alternativen bevorzugten Ausführungsform der vorliegenden Erfindung, werden eine erste Hauptkomponente 4c und eine zu dieser identische zweite Hauptkomponente 4c' zur Verfügung gestellt, wobei die erste und die zweite Hauptkomponente 4c und 4c' jeweils ein Stromversorgungsmodul 2a und 2a' und jeweils ein Kühlmodul 2b und 2b' aufweisen. Die erste und die zweite Hauptkomponente 4c und 4c' weisen jeweils einen Eingang für dieselbe Wechselstromquelle und einen ersten Ausgang für eine Kühlmittelleitung 8 und 8' und einen zweiten Ausgang für Gleichstrom auf. Die Ladestation 1 weist ferner eine erste Ladesäule 12 auf, die mit der ersten Hauptkomponente 4c mittels Kühlmittelleitung 8 und Gleichstromleitung 9 verbunden ist. Die Ladestation 1 weist ferner eine zweite Ladesäule 12' auf, die mit der zweiten Hauptkomponente 4c' mittels Kühlmittelleitung 8' und Gleichstromleitung 9' verbunden ist.
Es wird hiermit vorteilhaft eine Ladestation 1 mit zwei Ladesäulen 12 und 12' zur Verfügung gestellt, die beide aus derselben Wechselstromquelle gespeist werden. Es ist hiermit vorteilhaft möglich, beispielsweise bis zu zwei Elektrofahrzeuge gleichzeitig mit elektrischer Energie aufzuladen.

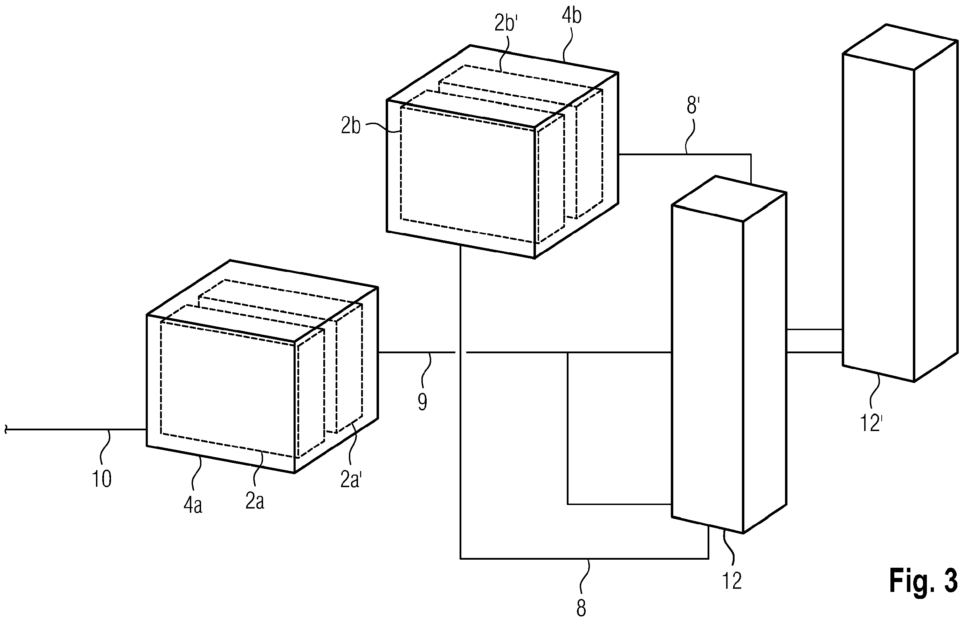

In Figur 3 ist eine Ladestation 1 mit einer Stromversorgungskomponente 4a und einer Kühlkomponente 4b und zwei Ladesäulen 12 und 12' gemäß der vorliegenden Erfindung schematisch dargestellt.

In einer alternativen bevorzugten Ausführungsform der vorliegenden Erfindung, werden eine erste Hauptkomponente 4a und eine zweite Hauptkomponente 4b zur Verfügung gestellt. Die erste Hauptkomponente 4a weist zwei Stromversorgungsmodule 2a und 2a' auf, die über einen Eingang für eine Wechselstromquelle mit Wechselstrom gespeist werden. Die erste Hauptkomponente 4a weist ferner einen Ausgang für Gleichstrom auf. Die zweite Hauptkomponente 4b weist zwei Kühlmodule 2b und 2b' und einen ersten und einen zweiten Ausgang für eine erste und eine zweite Kühlmittelleitung 8 und 8' auf. Die Ladestation weist ferner eine erste und eine zweite Ladesäule 12 und 12' auf, wobei die erste Ladesäule 12 mit dem ersten Ausgang der Kühlkomponenten 4b mittels der ersten Kühlleitung 8 verbunden ist und die zweite Ladesäule 12' mit dem zweiten Ausgang der Kühlkomponente 4b' mittels der zweiten Kühlleitung 8' verbunden ist. Es werden nur die Ladesäulen 12 und 12' durch die Kühlkomponente 4b gekühlt. Eine Kühlung der Stromversorgungskomponente 4a durch die Kühlkomponente 4b findet nicht statt. Die erste Hauptkomponente 4a versorgt die erste und die zweite Ladesäule 12 und 12' mit Gleichstrom mittels einer mit dem ersten Ausgang der Hauptkomponente 4a verbundenen, sich in zwei Leitungen verzweigenden Gleichstromleitung 9.
Es wird hiermit vorteilhaft eine Ladestation 1 mit zwei Ladesäulen 12 und 12' zur Verfügung gestellt, wobei die Kühlung unabhängig von der Stromversorgung platziert werden kann. Es ist hiermit vorteilhaft möglich, beim Aufbau der Ladestation 1 örtliche Gegebenheiten und Beschränkungen zu berücksichtigen.

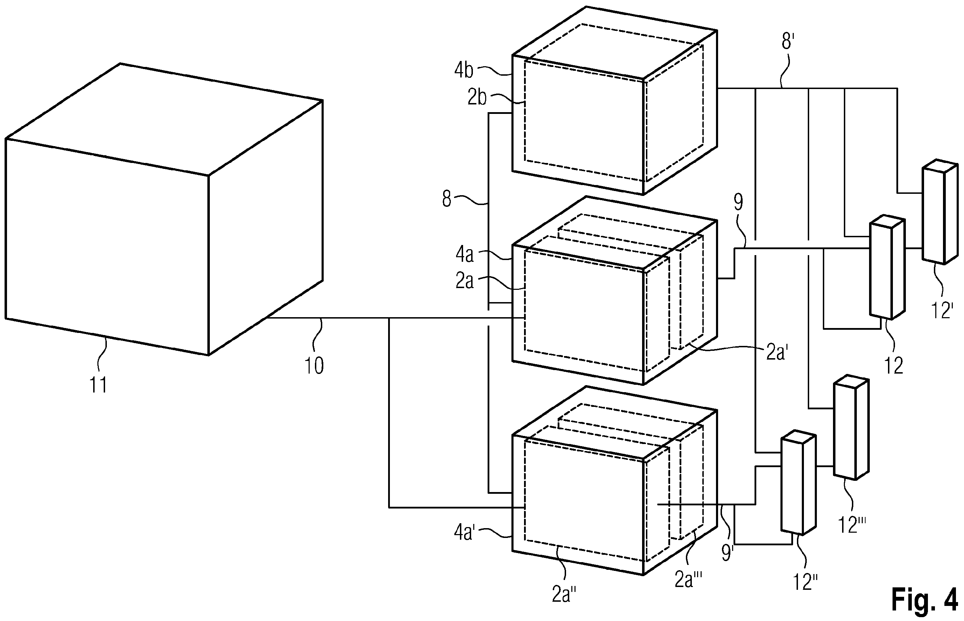

In Figur 4 ist eine Ladestation 1 mit zwei Stromversorgungskomponenten 4a und 4a', einer Kühlkomponente 4b und vier Ladesäulen 12, 12', 12" und 12'" gemäß der vorliegenden Erfindung schematisch dargestellt.
In einer weiteren alternativen Ausführungsform der vorliegenden Erfindung, werden eine erste, eine zweite und eine dritte Hauptkomponente 4b, 4a und 4a' zur Verfügung gestellt. Dabei weist die erste Hauptkomponente 4b zwei Kühlmodule 2b und 2b' mit einem ersten und einem zweiten Ausgang für eine erste und eine zweite Kühlmittelleitung 8 und 8' auf. Die zweite und die dritte Hauptkomponente 4a und 4a' weisen jeweils zwei Stromversorgungsmodule 2a, 2a' und 2a", 2a'" mit jeweils einem Eingang für Wechselstrom und jeweils einen Ausgang für Gleichstrom auf. Die zweite und die dritte Hauptkomponente 4a und 4a' weisen jeweils einen Eingang für eine Kühlmittelleitung 8 auf, mittels derer sie mit dem ersten Ausgang der Kühlkomponente 4b verbunden sind. Die Ladestation 1 weist ferner vier Ladesäulen 12, 12', 12" und 12'" auf, die über den zweiten Ausgang der Kühlkomponente 4b mit einer sich vierfach verzweigenden Kühlleitung 8' mit der Kühlkomponente 4b verbunden sind. Die Kühlkomponente 4b kühlt sowohl die Stromversorgungskomponenten 4a und 4a' als auch die vier Ladesäulen 12, 12', 12" und 12'". Die erste Stromversorgungskomponente 4a ist am Gleichstromausgang der ersten Stromversorgungskomponente 4a über eine sich verzweigende Gleichstromleitung 9 mit der ersten und der zweiten Ladesäule 12 und 12' verbunden. Die zweite Stromversorgungskomponente 4a' ist am Gleichstromausgang der ersten Stromversorgungskomponente 4a' über eine sich verzweigende Gleichstromleitung 9' mit der dritten und der vierten Ladesäule 12" und 12'" verbunden. Die Ladestation 1 weist ferner eine Transformationsstation 11 auf. Diese versorgt die erste und die zweite Stromversorgungskomponente 4a und 4a' über eine sich verzweigende Wechselstromleitung 10 zu den Wechselstromeingängen der jeweiligen Hauptkomponente mit Wechselstrom.
Es wird hiermit vorteilhaft eine Ladestation 1 mit vier Ladesäulen 12, 12', 12" und 12'" zur Verfügung gestellt, an der beispielsweise bis zu vier Elektrofahrzeuge gleichzeitig aufgeladen werden können. Vorteilhaft sind Kühlung und Stromversorgung in verschiedenen Hauptkomponenten umgesetzt. Während die Platzierung der Stromversorgungskomponenten von dem Ort der Transformationsstation abhängt, unterliegt die Platzierung der Kühlung keiner solchen Beschränkung. Der modulare Aufbau der Ladestation erlaubt auch hier, auf die örtlichen Gegebenheiten und Anforderungen flexibel einzugehen.

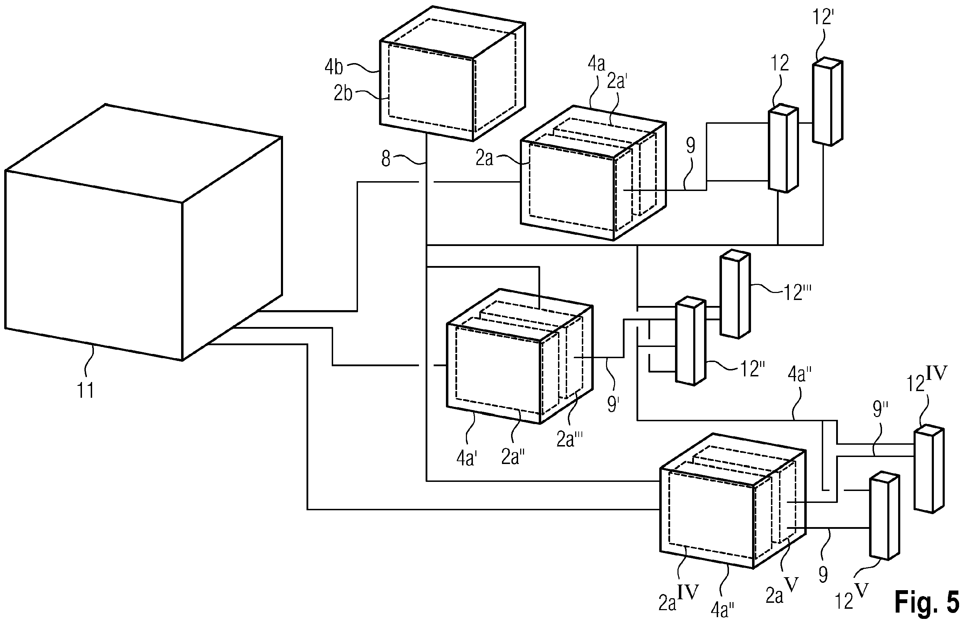

In Figur 5 ist eine Ladestation 1 mit drei Stromversorgungskomponenten 4a. 4a' und 4a", einer Kühlkomponente 4b und sechs Ladesäulen 12, 12', 12", 12'", 12^{IV} und 12^{V} gemäß der vorliegenden Erfindung schematisch dargestellt.

In einer weiteren bevorzugten Ausführungsform der vorliegenden Erfindung, weist die Ladestation 1 sechs Ladesäulen 12, 12', 12", 12"', 12^{IV} und 12^{V} auf. Die Ladestation 1 weist ferner eine erste Kühlkomponente 4b auf, die ein Kühlmodul 2b und einen Ausgang für eine Kühlmittelleitung 8 aufweist, auf. Die Ladestation 1 weist ferner eine erste und eine zweite Stromversorgungskomponente 4a und 4a' auf, wobei die erste und die zweite Stromversorgungskomponente 4a und 4a' jeweils zwei Stromversorgungsmodule 2a, 2a' und 2a", 2a'" und jeweils einen Eingang für Wechselstrom und einen Ausgang für Gleichstrom aufweisen. Die Ladestation 1 weist weiterhin eine dritte Stromversorgungskomponente 4a" auf, die zwei Stromversorgungsmodule 2a^{IV}, 2a^{V} und einen Wechselstromeingang und einen ersten und einen zweiten Gleichstromausgang, sowie einen jeweils einen Eingang für jeweils eine Kühlmittelleitung aufweist. Die Ladestation 1 weist ferner eine Transformationsstation 11 auf, die über je eine Wechselstromleitung 10, 10' und 10" jeweils mit dem Wechselstromeingang der ersten, zweiten und dritten Stromversorgungskomponente 4a, 4a' und 4a" verbunden ist. Die Kühlkomponente 4b kühlt über mit dem Ausgang der Kühlkomponente 4b verbundenen, sich verzweigenden Kühlmittelleitungen 8 die zweite und dritte Stromkomponente 4a' und 4a" sowie die sechs Ladesäulen 12, 12', 12", 12'", 12^{IV} und 12^{V}. Die erste und zweite Ladesäule 12 und 12' werden über aus dem Gleichstromausgang der ersten Stromkomponente 4a sich verzweigenden Gleichstromleitung 9 mit Gleichstrom versorgt. Die dritte und vierte Ladesäule 12" und 12'" werden über aus dem Gleichstromausgang der zweiten Stromkomponente 4a' sich verzweigenden Gleichstromleitung 9' mit Gleichstrom versorgt. Die fünfte Ladesäule 12^{IV} wird aus dem ersten Gleichstromausgang der dritten Stromversorgungskomponente 4a" mittels der Gleichstromleitung 9" mit Gleichstrom versorgt. Die sechste Ladesäule 12^{V} wird aus dem zweiten Gleichstromausgang der dritten Stromversorgungskomponente 4a" mittels der Gleichstromleitung 9'" mit Gleichstrom versorgt.

Es wird hiermit vorteilhaft eine Ladestation 1 mit sechs Ladesäulen 12, 12', 12", 12'", 12^{IV} und 12^{V} zum gleichzeitigen Aufladen von beispielsweise bis zu sechs Elektrofahrzeugen zur Verfügung gestellt.

### Bezugszeichenliste

- 1: Ladestation
- 2a: Stromversorgungsmodul
- 2b: Kühlmodul
- 4a: Stromversorgungskomponente
- 4b: Kühlkomponente
- 4c: Stromversorgungs-Kühl-Kombinationskomponente
- 7: Gehäuse
- 8: Kühlmittelleitung
- 9: Gleichstromleitung
- 10: Wechselstromleitung
- 11: Transformationsstation
- 12: Ladesäule

## Patentansprüche

1. Ladestationssystem, insbesondere für Elektrofahrzeuge, wobei das Ladestationssystem mindestens ein Gehäuse (7) aufweist, wobei das Ladestationssystem eine Mehrzahl an Hauptkomponenten (4) aufweist, **dadurch gekennzeichnet, dass** das Gehäuse (7) und die Hauptkomponenten (4) so standardisiert sind, dass sich die Hauptkomponenten (4) im Gehäuse (7) modular anordnen lassen.

2. Ladestationssystem nach Anspruch 1, wobei die Hauptkomponenten (4) und das Gehäuse (7) in ihren Maßen eine aufeinander abgestimmte Standardisierung aufweisen, wobei insbesondere das Gehäuse (7) Innenmaße aufweist, die durch die Außenmaße der Hauptkomponenten (4) bestimmt sind.

3. Ladestationssystem nach einem der vorhergehenden Ansprüche, wobei das Ladestationssystem eine Mehrzahl an Hauptkomponenten (4) aufweist, wobei jede dieser Hauptkomponenten einen Schaltschrank aufweist, wobei die Hauptkomponente (4) mindestens ein Modul (2) aufweist, wobei die Architektur des Moduls (2) **dadurch gekennzeichnet ist, dass** sich das Modul (2) im Schaltschrank modular anordnen lässt.

4. Ladestationssystem nach Anspruch 3, wobei das Ladestationssystem mindestens eine Hauptkomponente (4) aufweist, wobei die Hauptkomponente (4) eine Mehrzahl an Modulen (2) aufweist, **dadurch gekennzeichnet, dass** die Module (2) ausschließlich Stromversorgungsmodule (2a) sind.

5. Ladestation nach einem der vorhergehenden Ansprüche, wobei das Ladestationssystem mindestens eine Hauptkomponente (4) aufweist, wobei die Hauptkomponente (4) eine Mehrzahl an Modulen (2) aufweist, **dadurch gekennzeichnet, dass** die Hauptkomponente (4) mindestens ein Stromversorgungsmodul (2a) und ein Kühlmodul (2b) aufweist.

6. Ladestation nach einem der vorhergehenden Ansprüche, wobei das Ladestationssystem mindestens eine Hauptkomponente (4) aufweist, wobei die Hauptkomponente (4) eine Mehrzahl an Modulen (2) aufweist, **dadurch gekennzeichnet, dass** die Module (2) ausschließlich Kühlmodule (2b) sind.

7. Ladestationssystem nach einem der vorhergehenden Ansprüche, wobei das Ladestationssystem eine Ladesäule (12) aufweist.

8. Ladestationssystem nach einem der vorhergehenden Ansprüche, wobei das Ladestationssystem eine Transformationsstation (11) aufweist.

9. Ladestationssystem nach einem der vorhergehenden Ansprüche, wobei das mindestens eine Gehäuse (7) aus Stahlblech, Stahlplatten oder Beton gefertigt ist.

10. Ladestationssystem nach einem der vorhergehenden Ansprüche, wobei das mindestens eine Gehäuse (7) genau eine Tür aufweist.

11. Ladestationssystem nach einem der vorhergehenden Ansprüche, wobei das Ladestationssystem ein erstes Gehäuse (7) und mindestens ein neben oder über dem ersten Gehäuse (7) befindliches, zweites Gehäuse (7) aufweist.

12. Verfahren zum Aufbau einer Ladestation nach einem der vorhergehenden Ansprüche, insbesondere für Elektrofahrzeuge, wobei in einem ersten Schritt mindestens ein standardisiertes Gehäuse (7) zur Verfügung gestellt wird, wobei in einem zweiten Schritt das mindestens eine standardisierte Gehäuse (7) mit einer ersten standardisierten Hauptkomponente (4) und mindestens einer zweiten standardisierten Hauptkomponente (4) modular bestückt wird und wobei in einem dritten Schritt die erste standardisierte Hauptkomponente (4) mit der zweiten standardisierten Hauptkomponente (4) verbunden wird.

13. Verfahren nach Anspruch 14, wobei in einem ersten Schritt ein erstes und ein zweites mit je mindestens einer standardisierten Hauptkomponente (4) bestücktes, standardisiertes Gehäuse (7) zur Verfügung gestellt wird, wobei in einem zweiten Schritt das erste standardisierte Gehäuse (7) neben oder auf dem zweiten standardisierten Gehäuse (7) aufgestellt wird und wobei in einem dritten Schritt das erste standardisierte Gehäuse (7) mit dem zweiten standardisierten Gehäuse (7) verbunden wird.
